# EUROPÄISCHE PATENTSCHRIFT

(11) **EP 0 458 832 B1**
(45) Veröffentlichungstag und Bekanntmachung des Hinweises auf die Patenterteilung: **10.05.1995**
(21) Anmeldenummer: 90903153.6
(22) Anmeldetag: 15.02.1990
(51) Int. Cl.: H05K 7/14

(54) **GERÄTESYSTEM MIT EINEM ERSTEN UND WENIGSTENS EINEM DARAN ANKUPPELBAREN ZWEITEN ELEKTRISCHEN GERÄT**
APPLIANCE SYSTEM COMPRISING A FIRST ELECTRICAL APPLIANCE AND AT LEAST A SECOND ELECTRICAL APPLIANCE COUPLED THERETO
SYSTEME D'APPAREILS COMPRENANT UN PREMIER APPAREIL ELECTRIQUE ET AU MOINS UN DEUXIEME APPAREIL ELECTRIQUE QUI LUI EST COUPLE

(30) Priorität: 15.02.1989 DE 8901771 U
(43) Veröffentlichungstag der Anmeldung: 04.12.1991
(73) Patentinhaber: Siemens Nixdorf Informationssysteme Aktiengesellschaft, 33102 Paderborn (DE)
(72) Erfinder: BAITZ, Günter, D-1000 Berlin (DE); KAMIN, Hartmut, D-1000 Berlin 10 (DE)
(74) Vertreter: Fuchs, Franz-Josef, Dr.-Ing.
(86) Internationale Anmeldenummer: EP9000246
(87) Internationale Veröffentlichungsnummer: WO9009731

(56) Entgegenhaltungen:
- FR-A- 2 365 932
- US-A- 4 479 198
- US-A- 4 725 244

## Beschreibung

Die Erfindung betrifft einen Gerätesatz der im Oberbegriff des Anspruches 1 genannten Art.

Es ist vielfach erwünscht, elektrische Geräte, beispielsweise Personal Computer, ausbaufähig zu gestalten. Der Benutzer kann beispielsweise als erste Ausbaustufe ein Grundgerät erwerben, welches einen bestimmten, zunächst ausreichenden Leistungsumfang hat. Zum Zwecke einer späteren Leistungserweiterung kann der Benutzer Zusatzgeräte erwerben, die mit dem Grundgerät mechanisch und elektrisch verbunden werden. Ein weiteres Anwendungsfeld für einen derartigen Gerätesatz ist ein aus mehreren Kleinrechnern bestehendes Netzwerk, welches mit einem Massenspeicher ausgerüstet werden soll. Die Kleinrechner stellen die Grundgeräte dar, während der Massenspeicher beispielsweise in Form von mehreren Magnetplattenspeichern in einem Zusatzgerät angeordnet ist, welches einem der Grundgeräte zugeordnet wird. Ein anderes Anwendungsgebiet für einen Gerätesatz der im Oberbegriff des Anspruches 1 genannten Art ist ein für die Verwendung in Kaufhäusern vorgesehenes Registrierkassensystem, bei welchem die sogenannte Masterkasse aus einem Grundgerät und einem damit gekuppelten, nur einmal erforderliche Baugruppen enthaltenden Zusatzgerät besteht, während die Slavekassen jeweils nur aus einem Grundgerät bestehen. Weitere Anwendungsgebiete sind zu Fertigungssystemen miteinander verbundene, rechnergesteuerte Werkzeugmaschinen, Bankterminalnetze usw.

Es ist ganz allgemein bekannt, ausbaufähige Geräte so auszulegen, daß von vorneherein Platz für leistungserweiternde Zusatzfunktionsbaugruppen vorgesehen wird. Ein Nachteil derartiger Geräte ist, daß ein Benutzer auch dann, wenn er nur die Grundausbaustufe des Gerätes benötigt, den nicht ausgenutzten Bauraum sowie die Stekkersysteme und die Verdrahtung für die nicht benötigten Funktionsbaugruppen erwerben und damit einen unangemessen großen Platzbedarf sowie unnötige Kosten in Kauf nehmen muß.

Durch die US-A-4,725,244 ist auch bereits ein Gerätesystem bekannt, bei welchem ein Grundgerät ein Chassis hat, an das verschiedene Zusatzgeräte mechanisch und elektrisch ankuppelbar sind, wobei die Gesamtanordnung mit einer Abdeckhaube abdeckbar ist. Ein Problem ergibt sich dabei mit dem Zusammenbau der Grund- und Zusatzgeräte, da geeignete Montageflächen fehlen. Die Zusatzgeräte müssen deshalb teils seitlich an das Grundgerät mit Hilfe von Schrauben angeschraubt werden oder von oben auf das Grundgerät aufgesetzt und mit diesem verriegelt werden. Dadurch wird die Montage der Geräte bzw. auch eine Demontage beispielsweise zu Servicezwekken umständlich und kann im wesentlichen nur von Fachkräften mit speziellen Werkzeugen ausgeführt werden.

Es ist die Aufgabe der Erfindung, einen Gerätesatz der im Oberbegriff des Anspruches 1 genannten Art zu schaffen, welcher in einfacher und preisgünstiger Weise einen modularen Aufbau entsprechend den jeweils bestehenden Leistungsanforderungen erlaubt, wobei die zusammengebauten Geräte in jeder Ausbaustufe eine ansprechende äußere Form aufweisen sollen und die mechanischen und elektrischen Verbindungen gegen unsachgemäße Behandlung und Beschädigung weitgehend geschützt sein sollen, und wobei die Montage und Demontage der einzelnen Baugruppenträger gegenüber bekannten Lösungen verbessert ist.

Diese Aufgabe ist erfindungsgemäß durch die im Anspruch 1 enthaltenen Merkmale gelöst.

Die Baugruppenträger weisen jeweils eine Bodenplatte und darauf im wesentlichen senkrecht stehende Trennwände auf. Über diese Trennwände können die jeweiligen Baugruppenträger großflächig aneinandergefügt werden. Außerdem bieten sie die Möglichkeit, die zusammenwirkenden mechanischen Kupplungseinrichtungen günstig zu gestalten; diese mechanischen Kupplungseinrichtungen sind erfindungsgemäß an beim Kuppeln zweier Baugruppenträger sich aneinanderlegenden Trennwänden dieser Baugruppenträger ausgebildet.

Jedes Gerät weist einen Baugruppenträger auf, welcher einerseits zur Aufnahme der Funktionsbaugruppen dieses Gerätes ausgebildet ist und an welchem andererseits die mechanischen Kupplungseinrichtungen angeordnet sind, die zum Kuppeln dieses Baugruppenträgers mit weiteren Baugruppenträgern dienen. Es werden demnach nicht komplette Geräte, sondern deren Baugruppenträger mechanisch zu größeren Baugruppenträgereinheiten miteinander verbunden. Diese Baugruppenträgereinheiten erlauben auch nach ihrem mechanischen Zusammenbau einen guten Zugang zu den einzelnen Funktionsbaugruppen. Diese können sodann in einfacher Weise durch innerhalb der Baugruppenträgereinheit verlaufende elektrische Verbinder miteinander elektrisch gekuppelt werden, so daß außerhalb der Geräte verlaufende Verbindungsmittel, beispielsweise Verbindungskabel, vermieden werden. Zur Abdeckung einzelner Baugruppenträger oder auch Baugruppenträgereinheiten dienen an deren Form und Größe angepaßte Abdeckhauben. Die Abdeckhauben für Baugruppenträgereinheiten werden nach dem mechanischen und elektrischen Kuppeln derselben aufgesetzt. Die Abdeckhauben überdecken sowohl die Trennfugen zwischen einzelnen Baugruppenträgern als auch die mechanischen Kupplungseinrichtungen und die elektrischen Verbinder, so daß die Baugruppenträgereinheiten einerseits ein gefälliges, in sich geschlossenes Aussehen erhalten und andererseits die mechanischen Kupplungseinrichtungen und die elektrischen Verbinder vor unsachgemäßer Behandlung bzw. Beschädigung geschützt sind.

In vielen Fällen besteht ein Gerätesystem aus einem auch selbstständig funktionierenden Grundgerät und einem oder mehreren nur zusammen mit dem Grundgerät funktionierenden Zusatzgeräten. In einem solchen Fall ist erfindungsgemäß vorgesehen, daß von mehreren miteinander gekuppelten Baugruppenträgern wenigstens eines, nämlich das Grundgerät, mit einem Kühlluftgebläse ausgerüstet ist und daß Übertrittskanäle für den Übertritt der Kühlluft vom ersten Baugruppenträger zu den damit gekuppelten weiteren Baugruppenträgern vorgesehen sind. Dadurch kann eine erhebliche bauliche Vereinfachung erzielt werden. Die unterschiedliche Kühlleistung für das Grundgerät einerseits, bzw. die aus Grundgerät und Zusatzgeräten bestehende Einheit andererseits kann beispielsweise durch unterschiedliche Drehzahlen des Kühlluftgebläses gesteuert werden. Um die gewünschte und erforderliche Verteilung der Kühlluft in der gesamten Einheit sicherzustellen, ist erfindungsgemäß vorgesehen, daß die Trennwände mit festen und/oder regelbaren Durchtrittsöffnungen für die Kühlluft versehen sind, wie anhand eines Ausführungsbeispieles noch genauer erläutert wird. Außerdem können in weiterer Ausgestaltung der Erfindung an den Baugruppenträgern Leitflächen vorgesehen sein, die die Kühlluft zu den Durchtrittsöffnungen leiten.

In einer bevorzugten Ausgestaltung der Erfindung steht die Druckseite des Kühlluftgebläses mit einem ersten Übertrittskanal in Verbindung, welcher an der einem anzukuppelnden Baugruppenträger zugewandten Außenseite des das Kühlluftgebläse tragenden Baugruppenträgers ausgebildet und nach außen hin offen ist; der anzukuppelnde Baugruppenträger weist an der dem ersteren Baugruppenträger zugewandten Außenseite wenigstens einen ebenfalls nach außen offenen, sich wenigstens teilweise mit dem ersten Übertrittskanal deckenden zweiten Übertrittskanal auf. An dieser Stelle kann die Kühlluft vom erstgenannten Baugruppenträger zum angekuppelten Baugruppenträger übertreten.

Die Funktionsbauträger einzelner gekuppelter Baugruppenträger können beispielsweise direkt über Verbindungskabel miteinander verbunden werden. Es besteht auch die Möglichkeit, die Anschlüsse der einzelnen Funktionsbaugruppen eines Baugruppenträgers in einem oder mehreren vielpoligen Steckern zu sammeln und diese über Verbindungskabel mit entsprechenden Steckern anderer Baugruppenträger zu verbinden. In bevorzugter Ausgestaltung der Erfindung ist jedoch vorgesehen, daß die Baugruppenträger jeweils wenigstens eine einerseits mit Steckverbindern zum Stecken von Funktionsbaugruppen und andererseits mit Anschlußkontakten für den Anschluß an Funktionsbaugruppen angekuppelter Baugruppenträger versehene Verdrahtungswand aufweisen. Diese Verdrahtungswand steht vorzugsweise senkrecht auf der Bodenplatte, wobei die Anschlußkontakte an der freien Oberkante, die Steckverbinder an der dem Baugruppenträgerinneren zugewandten Seitenfläche der Verdrahtungswand angeordnet sind. Die Verdrahtungswand kann in einem einzigen, einfachen Arbeitsschritt auf dem Baugruppenträger montiert werden und ermöglicht ihrerseits eine einfach Steckmontage aller Funktionsbaugruppen sowie der von einem Baugruppenträger zum anderen verlaufenden Verbindungskabel.

Die Trennwände der Baugruppenträger sind vorzugsweise mit Führungsrippen versehen, die als Montageschienen für die Funktionsbaugruppen und/oder die Verdrahtungswände dienen. In weiterer Ausgestaltung der Erfindung ist wenigstens ein Teil der Trennwände mit Durchführungsöffnungen für Verbindungskabel versehen derart, daß diese Verbindungskabel jeweils auf dem kürzesten oder sinnvollsten Weg verlegt werden können.

Wie weiter vorne bereits ausgeführt wurde, umfaßt das erfindungsgemäße Gerätesystem Abdeckhauben unterschiedlicher Form und Größe; sie sind beispielsweise an die Form und Größe einzelner selbständig funktionierender Grundgeräte oder auch an Baugruppenträgereinheiten unterschiedlichster Konstellation angepaßt. Sie sind je nach Bedarf mit Öffnungen für die Zuführung und Abführung von Kühlluft oder für die Durchführung von elektrischen Kabeln versehen. Außerdem können erfindungsgemäß an ihren Seitenwänden durch Blenden verschließbare, einen Zugang zu den Funktionsbaugruppen erlaubende Öffnungen vorgesehen sein. Diese Blenden können beispielsweise auch mit Bedienelementen für die Bedienung der hinter den Wänden angeordneten Funktionsbaugruppen ausgestattet sein.

In einer weiteren Ausgestaltung der Erfindung ist vorgesehen, daß die Baugruppenträger seitliche Einschuböffnungen zum Einschieben von Funktionsbaugruppen im wesentlichen in Richtung parallel zur Bodenplatte aufweisen.

Die Baugruppenträger weisen vorzugsweise wenigstens zwei Einschuböffnungen auf, deren Einschubrichtungen um 90 ° gegeneinander winkelversetzt sind. Dadurch besteht die Möglichkeit, einzelne Funktionsbaugruppen mit ihren Bedienungsfronten in zwei um 90 ° gegeneinander winkelversetzten Ausrichtungen anzuordnen, so daß beispielsweise bei Bauträgergruppeneinheiten mit rechteckigem Grundriß wahlweise beispielsweise eine schmale oder eine breite Seitenwand zur Frontseite gemacht werden kann.

Mehrere Ausführungsbeispiele der Erfindung sind in der Zeichnung dargestellt und im folgenden näher beschrieben. Es zeigen:
- Figur 1: einen Baugruppenträger mit Funktionsbaugruppen und einer Verdrahtungswand sowie eine dazu passende Abdeckhaube, jeweils in perspektivischer Darstellung;
- Figur 2: eine aus zwei gekuppelten Baugruppenträgern gebildete Baugruppenträgereinheit sowie eine dazu passende Abdeckhaube, jeweils in perspektivischer Darstellung;
- Figur 3: die Baugruppenträgereinheit nach Figur 2 vor ihrem mechanischen Zusammenkuppeln aus einer gegenüber Figur 2 geänderten Blickrichtung;
- Figur 4: eine Einzelheit der Baugruppenträgereinheit nach Figur 2 und 3 in einer Draufsicht;
- Figur 5: eine Einzelheit der Baugruppenträgereinheit nach Figur 2 und 3 im Bereich eines Rasthakens zum Zusammenkuppeln;
- Figur 6: in perspektivischer Darstellung eine durch eine Abdeckhaube abgedeckte Baugruppenträgereinheit, wobei die Abdeckhaube durch Blenden abdeckbare Zugangsöffnungen hat;
- Figur 7: schematisch eine aus vier gekuppelten Baugruppenträgern gebildete Baugruppenträgereinheit mit einer dazu passenden Abdeckhaube.

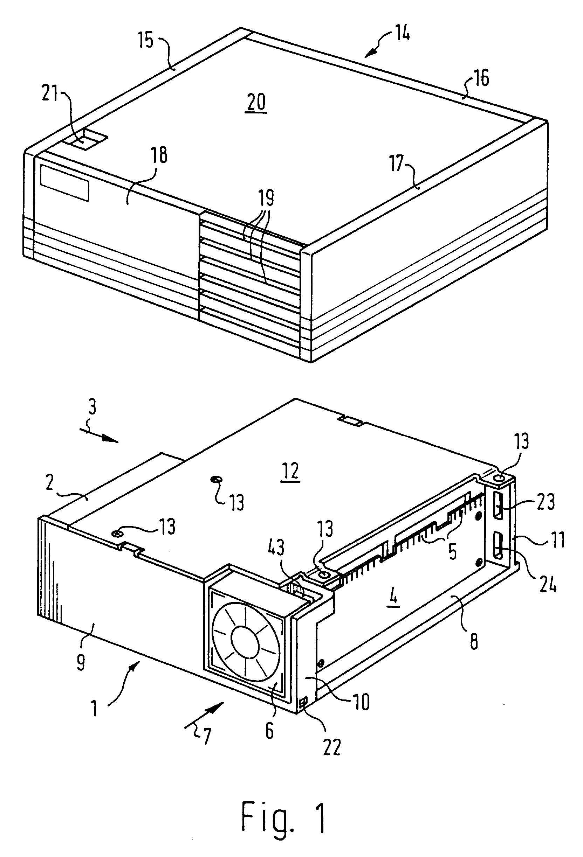

Figur 1 zeigt einen Baugruppenträger 1 zur Aufnahme elektrischer und mechanischer Funktionsbaugruppen. Beispielhaft ist ein elektrisches Stromversorgungsteil 2 dargestellt, welches in Richtung des Pfeiles 3 in den Baugruppenträger 1 eingeschoben wird, ferner eine Verdrahtungswand 4, die einerseits auf ihrer dem Stromversorgungsteil 2 zugewandten Fläche nicht dargestellte Steckverbinder aufweist, andererseits an ihrer Oberkante mit Kontaktelementen 5 versehen ist, die beispielsweise über Verbindungskabel mit anderen Funktionsbaugruppen verbunden werden können; mit 6 ist ein Kühlluftgebläse bezeichnet, welches ebenfalls als Funktionsbaugruppe in Richtung des Pfeiles 7 in den Baugruppenträger 1 eingeschoben und über am Kühlluftgebläse 6 einerseits und am Baugruppenträger 1 bzw. dem Stromversorgungsteil 2 andererseits angeordnete Steckverbinder mit Strom versorgt werden kann. Der Baugruppenträger 1 weist eine Bodenplatte 8 und darauf im wesentlichen senkrecht stehende Trennwände, beispielsweise die in Figur 1 sichtbaren äußeren Trennwände 9, 10 und 11 auf. Diese Trennwände begrenzen verschiedene Aufnahmeabteilungen für unterschiedliche Funktionsbauteile, wie weiter hinten noch genauer erläutert werden wird. Ein Deckel 12, der auf Trennwänden, beispielsweise den äußeren Trennwänden 9, 10 und 11, aufliegt, und mit diesen mittels Schrauben 13 verbunden ist, schließt den Baugruppenträger 1 nach oben ab.

Die Abdeckhaube 14 ist unten offen und im übrigen rundum geschlossen. Sie ist an die Form und Größe des Baugruppenträgers 1 exakt angepaßt und kann von oben über den Baugruppenträger 1 gestülpt und mit diesem in bekannter, hier nicht dargestellter Weise verbunden werden. Einzelne Seitenwände 15, 16, 17 sind als von der Abdeckhaube 14 lösbare Blenden ausgebildet, die beispielsweise ohne Demontage der ganzen Abdeckhaube entfernt werden können und den Zugang zu einzelnen Funktionsbaugruppen ermöglichen. Die Abdeckhaube 14 ist außerdem an einer Seitenwand 18 mit schlitzförmigen Öffnungen 19 versehen, die nach dem Aufsetzen der Abdeckhaube 14 auf den Baugruppenträger 1 vor dem Kühlluftgebläse 6 liegen und als Kühllufteinlaßöffnungen dienen. Die Deckwand 20 der Abdeckhaube 14 hat außerdem eine Öffnung 21 zur Durchführung von nicht dargestellten Kabeln, mit denen das in Figur 1 dargestellte Gerät beispielsweise mit auf dieses aufgesetzten weiteren Geräten verbunden werden kann.

Die Trennwand 10 ist mit einer Aufnahmeöffnung 22, die Trennwand 11 mit Aufnahmeöffnungen 23, 24 versehen, die in später zu beschreibender Weise zum Ankuppeln eines weiteren Baugruppenträgers an den Baugruppenträger 1 dienen.

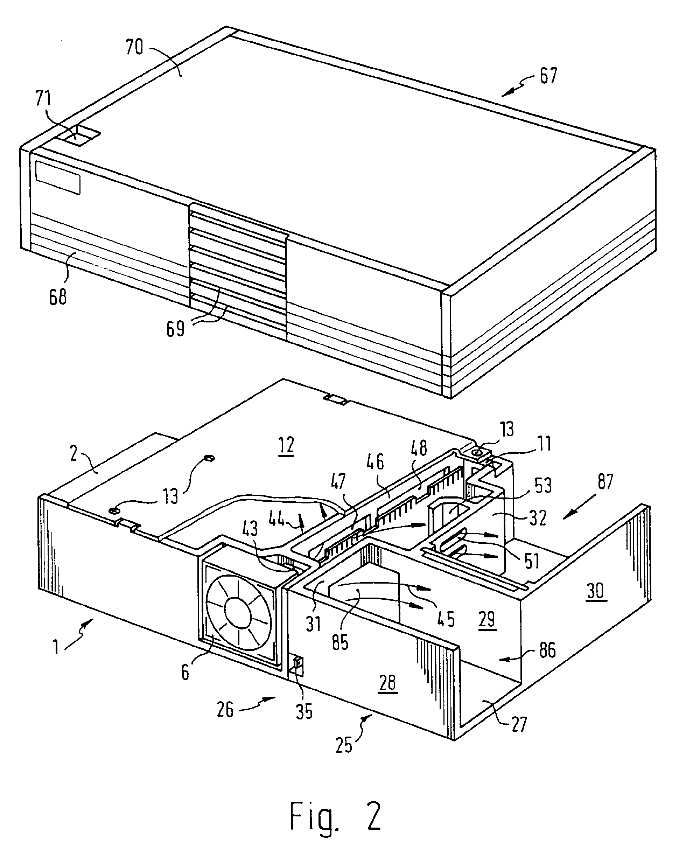

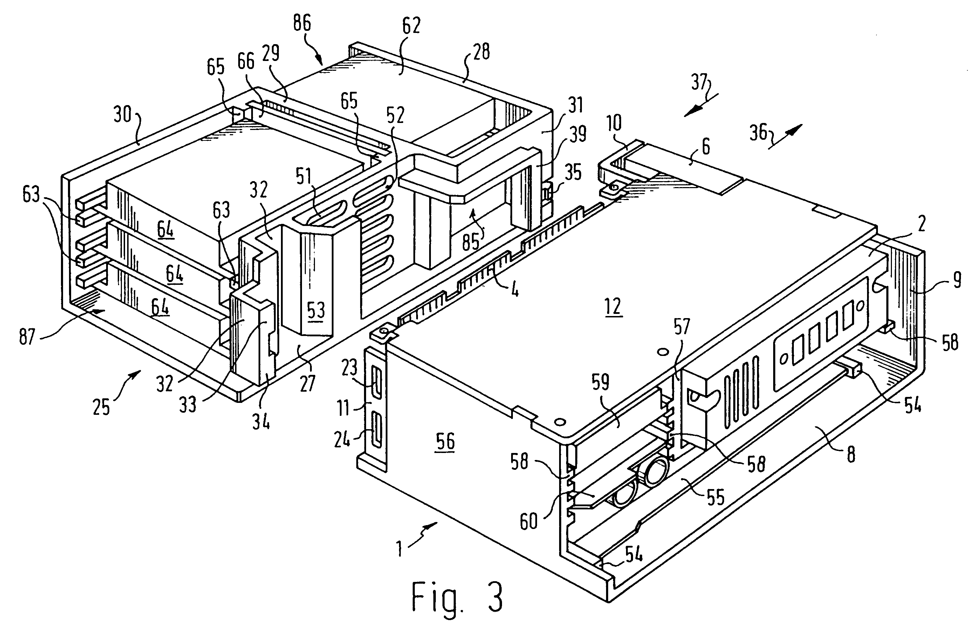

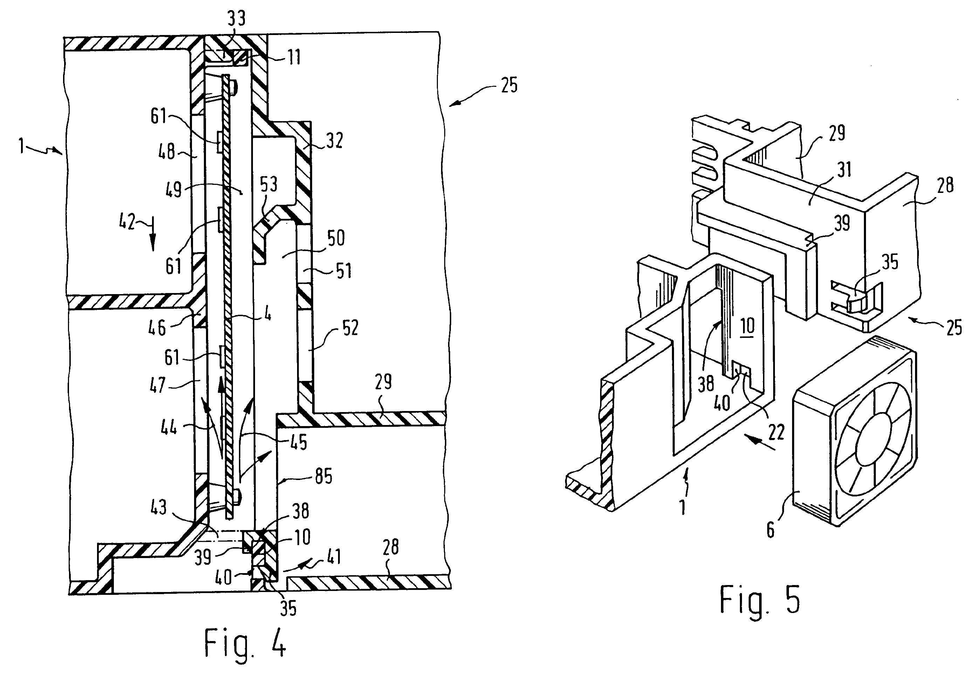

Figur 2 zeigt den Baugruppenträger 1 aus Figur 1, welcher mit einem weiteren Baugruppenträger 25 mechanisch gekuppelt ist. Die Baugruppenträger 1 und 25 bilden zusammen eine Baugruppenträgereinheit 26. Der Baugruppenträger 25 hat wiederum eine Bodenplatte 27, auf der mehrere Trennwände 28, 29, 30, 31 und 32 im wesentlichen senkrecht stehen. Diese Trennwände bilden verschiedene Aufnahmeabteilungen für unterschiedliche Funktionsbaugruppen, wie insbesondere anhand der Figur 3 erläutert wird. Die Figur 3 zeigt die Baugruppenträger 1 und 25 in entkuppeltem Zustand und in einer der Blickrichtung der Figur 2 entgegengesetzten Blickrichtung. Die Trennwand 32 des Baugruppenträgers 25 ist im Bereich ihres freien Endes mehrfach gekröpft und läuft in zwei Riegelnasen 33, 34 aus, die komplementär zu den Aufnahmeöffnungen 23, 24 der Trennwand 11 ausgebildet sind, wie insbesondere Figur 3 zeigt. In dem von den Trennwänden 28 und 31 gebildeten Eckbereich ist ein federnder Rasthaken 35 ausgebildet, welcher für den Eingriff in die Aufnahmeöffnung 22 der Trennwand 10 ausgebildet ist. Zum Kuppeln der Baugruppenträger 1 und 25 werden diese mit ihren einander zugewandten Seiten gegeneinander angelegt, wobei der Baugruppenträger 1 gegenüber dem Baugruppenträger 25 in Richtung des Pfeiles 36 versetzt ist. Dann wird der Baugruppenträger 1 in Richtung des Pfeiles 37 gegenüber dem Baugruppenträger 25 verschoben, bis die Riegelnasen 33, 34 in die Aufnahmeöffnungen 23, 24 eingreifen. Dabei greift gleichzeitig die in Verschieberichtung vordere Kante 38 der Trennwand 10 hinter eine an der Trennwand 31 des Baugruppenträgers 25 ausgebildete Haltenase 39 (siehe dazu auch Figuren 4 und 5), und der Rasthaken 35 greift hinter die durch eine Begrenzungsfläche der Öffnung 22 gebildete Rastfläche 40. Auf diese Weise werden die Baugruppenträger 1 und 25 miteinander so gekuppelt, daß sie sich nicht voneinander abheben und nicht gegeneinander verschieben können. Zum Lösen der Baugruppenträger voneinander muß der Rasthaken 35 mit einem Werkzeug in Richtung des Pfeiles 41 gebogen werden, bis er von der Rastfläche 40 freikommt. Dann kann der Baugruppenträger 1 in Richtung des Pfeiles 42 verschoben werden, bis die Kante 38 der Trennwand 10 hinter der Nase 39 freikommt und die Riegelnasen 33, 34 aus den Aufnahmeöffnungen 22, 23 zurückgezogen sind (s. Fig. 4).

Wie insbesondere die Figur 2 erkennen läßt, ist für die gesamte Baugruppenträgereinheit 26 nur ein Kühlluftgebläse 6 vorgesehen, dessen Kühlluft auf beide Baugruppenträger 1 bzw. 25 verteilt wird. Das Kühlluftgebläse 6 wird in eine durch Trennwände gebildete Aufnahmeabteilung des Baugrupptenträgers 1 eingeschoben und in der schon beschriebenen Weise über Steckverbinder mit den übrigen Funktionsbaugruppen, insbesondere dem Stromversorgungsteil 2 verbunden. Die die Aufnahmeabteilung für das Kühlluftgebläse 6 bildenden Trennwände weisen wenigstens eine Öffnung 43 auf, durch die die Kühlluft ins Innere des Baugruppenträgers 1 gelangt. Die Verdrahtungswand 4 ist hinter der Öffnung 43 etwa in Abströmrichtung der Kühlluft so angeordnet, daß sie den Kühlluftstrom in zwei Teilströme 44 und 45 teilt (siehe Figur 4). Die Verdrahtungswand 4 begrenzt zusammen mit der inneren Trennwand 46 einen inneren Kanal für den Teilstrom 44, welcher durch in der Trennwand 46 ausgebildete Öffnungen 47, 48 in die Aufnahmeabteilungen für die verschiedenen Funktionsbaugruppen strömen kann. Die Verdrahtungswand 4 bildet außerdem die innere Begrenzungswand eines nach außen, d.h. zum angekuppelten Baugruppenträger 25 hin, offenen Übertrittskanals 49 für den Teilstrom 45. Der Baugruppenträger 25 weist an seiner dem Baugruppenträger 1 zugewandten Seite ebenfalls einen nach außen offenen Übertrittskanal 50 auf, dessen innere Begrenzung durch die Trennwand 33 gebildet wird. Die Übertrittskanäle 49 und 50 überdecken sich wenigstens teilweise, so daß der Kühlluftstrom 45 über den Übertrittskanal 50 in den Baugruppenträger 25 übertreten kann. In der Trennwand 32 sind Durchtrittsöffnungen 51, 52 ausgebildet, durch die die Kühlluft in die Aufnahmeabteilungen für die Funktionsbauteile übertreten kann. Außerdem ist an der Trennwand 32 noch eine Leitfläche 53 angeordnet, welche die Kühlluft verstärkt den Durchtrittsöffnungen 51, 52 zuführt. Die in der Trennwand 31 ausgebildete Öffnung 85 dient beispielsweise gleichzeitig als Durchtrittsöffnung für Kühlluft und als Durchführungsöffnung für zwischen den Baugruppenträgern 1 und 25 verlaufende Verbindungskabel.

Anhand der Figur 3 sei eine typische Bestückung zweier miteinander zu kuppelnder Baugruppenträger beschrieben. Parallel zur Bodenplatte 8 des Baugruppenträgers 1 ist zwischen an der Bodenplatte angeordnete Führungsschienen 54 eine Elektronikbaugruppe 55 eingeschoben, die im wesentlichen die ganze Bodenplatte 8 überdeckt. Die Trennwände 56, 57 und 9 sind ebenfalls jeweils mit Führungsschienen 58 versehen, in die unterschiedliche Funktionsbaugruppen einschiebbar sind. In der zwischen den Trennwänden 9 und 57 gebildeten Aufnahmeabteilung ist das schon weiter vorne beschrieben Stromversorgungsteil 2 eingeschoben. In die zwischen den Trennwänden 57, 58 gebildete Aufnahmeabteilung werden weitere Elektronikbaugruppen 59, 60 eingeschoben. Alle Funktionsbaugruppen 55, 2, 59 und 60 sind in bekannter, hier nicht dargestellter Weise über an ihnen ausgebildete Steckverbinder mit Steckverbindern 61 (siehe Figur 4) auf der Verdrahtungswand 4 in Eingriff und so elektrisch miteinander verbunden. Das aus dem Baugruppenträger 1 und den davon aufgenommenen Funktionsbaugruppen gebildete Gerät ist beispielsweise ein für sich funktionsfähiges Grundgerät.

Zwischen den Trennwänden 28 und 29 des Baugruppenträgers 25 ist beispielsweis ein Magnetplattenlaufwerk 62 angeordnet, welches durch die Einschuböffnung 86 eingeschoben worden ist. An den Trennwänden 30, 32 sind wiederum Führungsschienen 63 ausgebildet, in die weitere Elektronikbaugruppen 64 durch die Einschuböffnung 87 eingeschoben werden können. Ebenfalls an den Trennwänden 30, 32 sind vertikale Führungsschienen 65 ausgebildet, in die eine Verdrahtungswand 66 eingeschoben ist, über die in der schon anhand des Baugruppenträgers 1 beschriebenen Weise die Funktionsbaugruppen 62, 64 des Baugruppenträgers 25 elektrisch miteinander verbunden werden.

Figur 2 zeigt außerdem eine Abdeckhaube 67, die hinsichtlich Größe und Form so ausgebildet ist, daß sie die gesamte Baugruppenträgereinheit 26 abdeckt und ihr das Aussehen eines einzigen Gerätes gibt. An der Seitenwand 68 der Abdeckhaube 67 sind wiederum schlitzförmige Öffnungen 69 ausgebildet, die als Einlässe für die von dem Kühlluftgebläse angesaugte Kühlluft dienen. In der Deckwand 70 ist eine Öffnung 71 für eine Kabeldurchführung vorgesehen.

Wie insbesondere die Figuren 2 und 3 erkennen lassen, sind die Einschuböffnungen zum Einschieben der unterschiedlichen Funktionsbaugruppen in die Aufnahmeabteilungen des Baugruppenträgers 25 so angeordnet, daß sich um 90° gegeneinander winkelversetzte Einschubrichtungen ergeben. Diese Anordnung ermöglicht es, die Funktionsbaugruppen so einzusetzen, daß ihre Bedienungsfront entweder an einer Schmalseite oder an einer Längsseite der gesamten Baugruppenträgereinheit angeordnet ist, so daß das komplette Gerät entweder mit einer Schmalseite oder mit einer Längsseite zum Benutzer hin aufgestellt werden kann.

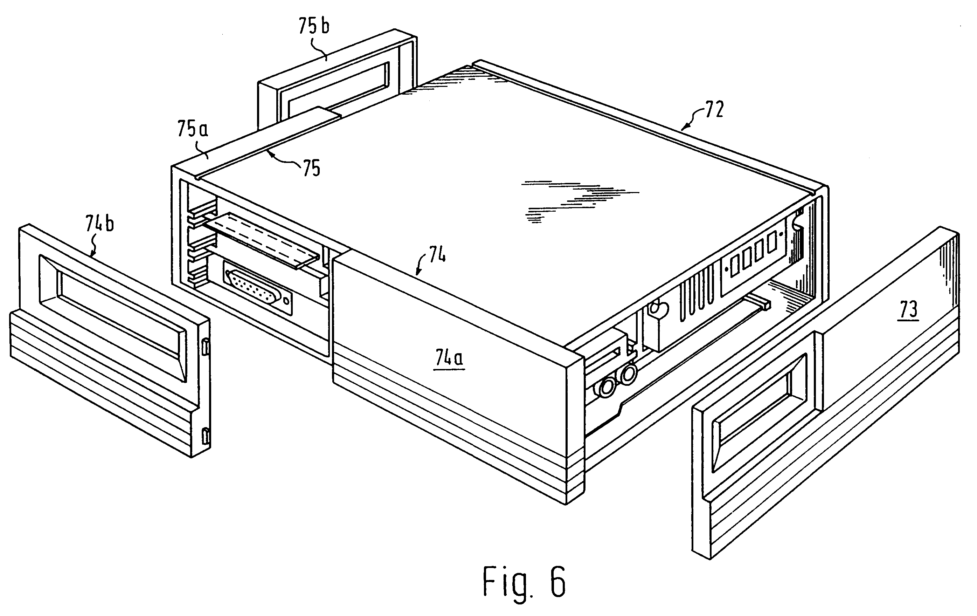

Figur 6 zeigt eine Baugruppenträgereinheit, die aus zwei Baugruppenträgern etwa gemäß Figur 3 zusammengesetzt und durch eine die gesamte Einheit überdeckende Abdeckhaube 72 abgedeckt ist. Die Seitenwand 73 ist als Blende ausgebildet, die abnehmbar ist und auf diese Weise den Zugang zu den hinter dieser Blende angeordneten Funktionsbaugruppen ermöglicht. Die Seitenwand 74 besteht aus einem fest mit der Abdeckhaube 72 verbundenen Teil 74a und einem abnehmbaren Teil 74b; in gleicher Weise besteht die Seitenwand 75 aus einem fest mit der Haube verbundenen Teil 75a und einem abnehmbaren Teil 75b. Die abnehmbaren Teile 74b und 75b erlauben ebenfalls den Zugang zu den dahinter angeordneten Funktionsbaugruppen, beispielsweise zum Zwecke ihrer Bedienung oder ihrer Wartung.

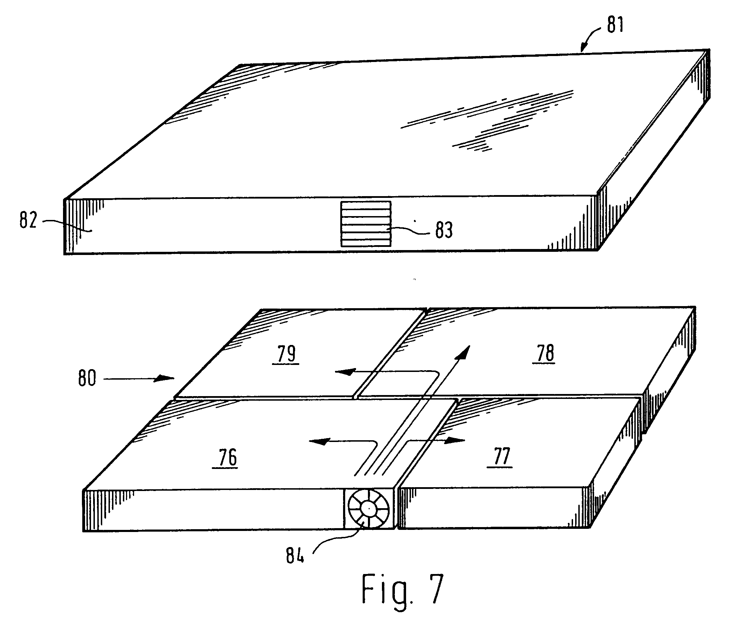

Figur 7 zeigt schematisch vier Baugruppenträger 76, 77, 78, 79, die in der vorne beschriebenen Weise miteinander gekuppelt sind und durch eine gemeinsame, der Form und Größe der durch die Baugruppenträger gebildeten Baugruppenträgereinheit 80 angepaßte Abdeckhaube 81 abgedeckt wird, so daß die fertig montierte Anordnung das Aussehen eines einzigen Gerätes hat. In der Seitenwand 82 ausgebildete Öffnungen 83 erlauben ein Ansaugen von Kühlluft durch das auf dem Baugruppenträger 76 angeordnete Kühlluftgebläse 84. Wie schematisch dargestellt ist, wird durch auf den Baugruppenträgern angeordnete Trennwände, Leitflächen und Luftdurchtrittsöffnungen der Kühlluftstrom auf alle Baugruppenträger verteilt.

## Patentansprüche

1. Gerätesystem mit einem ersten elektrischen Gerät, an welches wenigstens ein weiteres elektrisches Gerät mechanisch und elektrisch ankuppelbar ist, wobei die Geräte jeweils einen zur Aufnahme von Funktionsbaugruppen ausgebildeten Baugruppenträger (1, 25) haben, an denen jeweils mechanische Kupplungseinrichtungen (23, 24, 33, 34; 22, 35) zum Kuppeln eines Baugruppenträgers (1) mit weiteren Baugruppenträgern (25) angeordnet sind, und wobei an bestimmte Anordnungen miteinander gekuppelter Baugruppenträger angepaßte, diese jeweils abdekkende Abdeckhauben (14, 67) vorgesehen sind, dadurch **gekennzeichnet**, daß die Baugruppenträger (1, 25) jeweils auf einer Bodenplatte (8; 27) senkrecht stehende Trennwände (9, 10, 11, 56, 57; 28, 29, 30, 31, 32) haben und daß die Kupplungseinrichtungen (23, 24, 40; 33, 34 35) jeweils an beim Kuppeln zweier Baugruppenträger aneinanderstoßenden Trennwänden (10, 11; 31, 32) dieser Baugruppenträger (1; 25) ausgebildet sind.

2. Gerätesystem nach Anspruch 1, dadurch **gekennzeichnet**, daß die Kupplungseinrichtungen jeweils an einem Baugruppenträger (25) angeordnete Riegelnasen (33, 34) und an einem mit diesem Baugruppenträger (25) zu kuppelnden zweiten Baugruppenträger (1) angeordnete Aufnahmeöffnungen (22, 24) für die Riegelnasen (35) umfassen.

3. Gerätesystem nach Anspruch 1 oder 2, dadurch **gekennzeichnet**, daß die Kupplungseinrichtungen jeweils an einem Baugruppenträger (25) ausgebildete federnde Rasthaken (35) und an einem mit diesem Baugruppenträger (25) zu kuppelnden zweiten Baugruppenträger (1) ausgebildete, mit den Rasthaken zusammenwirkende Rastflächen (40) umfassen.

4. Gerätesystem nach einem der Ansprüche 1 bis 3, dadurch **gekennzeichnet**, daß von mehreren miteinander gekuppelten Baugruppenträgern (1; 25) wenigstens ein erster (1) mit einem Kühlluftgebläse (6) ausgerüstet ist und daß mit die Trennwände (32, 46) durchsetzenden Durchtrittsöffnungen (51, 47, 48) verbundene Übertrittskanäle (49, 50) für den Übertritt der Kühlluft vom ersten Baugruppenträger (1) zu den damit gekuppelten weiteren Baugruppenträgern (25) vorgesehen sind.

5. Gerätesystem nach Anspruch 4, dadurch **gekennzeichnet**, daß die Trennwände (32, 46) mit festen und/oder regelbaren Durchtrittsöffnungen (51, 47, 48) für die Kühlluft versehen sind.

6. Gerätesystem nach Anspruch 4 oder 5, dadurch **gekennzeichnet**, daß an den Baugruppenträgern Leitflächen (53) zum Ablenken von Kühlluft zu den Durchtrittsöffnungen (51) vorgesehen sind.

7. Gerätesystem nach einem der Ansprüch 4 bis 6, dadurch **gekennzeichnet**, daß die Druckseite des Kühlluftgebläses (6) mit einem ersten Übertrittskanal (49) in Verbindung steht, welcher an der einem anzukuppelnden Baugruppenträger (25) zugewandten Außenseite des ersten Baugruppenträgers (1) ausgebildet und nach außen hin offen ist, und daß der anzukuppelnde Baugruppenträger (25) an der dem ersten Baugruppenträger (25) zugewandten Außenseite wenigstens einen nach außen offenen, sich wenigstens teilweise mit dem ersten Übertrittskanal (49) deckenden zweiten Übertrittskanal (50) aufweist.

8. Gerätesystem nach einem der Ansprüche 1 bis 7, dadurch **gekennzeichnet**, daß die Baugruppenträger (1, 25) jeweils wenigstens eine einerseits mit Steckverbindern (61) zum Stecken von Funktionsbaugruppen und andererseits mit Anschlußkontakten (5) für den Anschluß an Funktionsbaugruppen angekuppelter Baugruppenträger (25, 1) versehene Verdrahtungswand (4, 66) aufweisen.

9. Gerätesystem nach Anspruch 8, dadurch **gekennzeichnet**, daß die Verdrahtungswand (4) im wesentlichen senkrecht auf der Bodenplatte (8) steht und daß die Anschlußkontakte (5) an der freien Oberkante, die Steckverbinder (61) an der dem Baugruppenträgerinneren zugewandten Seitenfläche der Verdrahtungswand (4) angeordnet sind.

10. Gerätesystem nach Anspruch 8 oder 9, dadurch **gekennzeichnet**, daß die Verdrahtungswand (4) zu einer Außenkante der Bodenplatte (8) parallel und dieser gegenüber nach innen versetzt angeordnet ist und die innere Begrenzungswand eines Übertrittskanals (49) bildet.

11. Gerätesystem nach einem der Ansprüche 8 bis 10, dadurch **gekennzeichnet**, daß die Verdrahtungswand (4)mit einer dazu parallelen Trennwand (46) einen inneren Kühlluftkanal bildet.

12. Gerätesystem nach einem der Ansprüche 1 bis 11, dadurch **gekennzeichnet**, daß die Trennwände (30, 32; 56, 57) mit Führungsrippen (63, 65; 58) versehen sind, die als Montageschienen für Funktionsbaugruppen (64, 59, 60) und/oder Verdrahtungswände (66) dienen.

13. Gerätesystem nach einem der Ansprüche 1 bis 12, dadurch **gekennzeichnet**, daß wenigstens ein Teil der Trennwände (Trennwand 31) mit Durchführungsöffnungen (85) für Verbindungskabel versehen ist.

14. Gerätesystem nach einem der Ansprüche 1 bis 13, dadurch **gekennzeichnet**, daß Abdeckhauben (14) jeweils einem Baugruppenträger (1) entsprechender Grundrißform und Größe sowie Abdeckhauben (67; 81) mit jeweils mehreren zusammengekuppelten Baugruppenträgern (1, 25; 76, 77, 78, 79) entsprechender Grundrißform und Größe vorgesehen sind.

15. Gerätesystem nach Anspruch 14, dadurch **gekennzeichnet**, daß die Abdeckhauben (14) mit Öffnungen (19) für die Zuführung und Öffnungen für die Abführung von Kühlluft versehen sind.

16. Gerätesystem nach Anspruch 14 oder 15, dadurch **gekennzeichnet**, daß die Abdeckhauben (14) mit Öffnungen (21) für die Durchführung von elektrischen Kabeln versehen sind.

17. Gerätesystem nach einem der Ansprüche 14 bis 16, dadurch **gekennzeichnet**, daß die Seitenwände (73, 74, 75) der Abdeckhauben (72) ganz oder teilweise als abnehmbare Blenden (74b, 75b) ausgebildet sind, welche einen Zugang zu den Funktionsbaugruppen erlaubende Öffnungen verschließen.

18. Gerätesystem nach einem der Ansprüche 1 bis 17, dadurch **gekennzeichnet**, daß die Baugruppenträger (25) seitliche Einschuböffnungen (86, 87) zum Einschieben von Funktionsbaugruppen (62, 64) im wesentlichen in Richtung parallel zur Bodenplatte (27) aufweisen.

19. Gerätesystem nach Anspruch 18, dadurch **gekennzeichnet**, daß die Baugruppenträger (25) wenigstens zwei Einschuböffnungen aufweisen, deren Einschubrichtungen um 90 ° gegeneinander winkelversetzt sind.

## Claims

1. Appliance system having a first electrical appliance, to which at least one further electrical appliance can be coupled mechanically and electrically, the appliances having in each case a mounting rack (1, 25) designed for accommodating functional assemblies, to which mounting racks in each case mechanical coupling devices (23, 24, 33, 34; 22, 35) are arranged for coupling a mounting rack (1) to further mounting racks (25), and cover hoods (14, 67) being provided which are matched to specific arrangements of mutually coupled mounting racks and cover these in each case, characterized in that the mounting racks (1, 25) have partitions (9, 10, 11, 56, 57; 28, 29, 30, 31, 32) which in each case stand perpendicularly on a baseplate (8; 27) and in that the coupling devices (23, 24, 40; 33, 34, 35) are in each case designed on partitions (10, 11; 31, 32) of these mounting racks (1; 25) which abut on one another when two mounting racks are coupled.

2. Appliance system according to Claim 1, characterized in that the coupling devices in each case comprise locking noses (33, 34) arranged on a mounting rack (25) and receiving openings (22, 24), arranged on a second mounting rack (1) to be coupled to this first mounting rack (25), for the locking noses (35).

3. Appliance system according to Claim 1 or 2, characterized in that the coupling devices in each case comprise resilient locking hooks (35) constructed on a mounting rack (25) and locking areas (40), constructed on a second mounting rack (1) to be coupled to this first mounting rack (25), which interact with the locking hooks.

4. Appliance system according to one of Claims 1 to 3, characterized in that, of a multiplicity of mounting racks (1; 25) coupled to each other, at least a first (1) is equipped with a cooling air blower (6), and in that transfer channels (49, 50), connected to passage openings (51, 47, 48) which penetrate the partitions (32, 46), are provided for the transfer of the cooling air from the first mounting rack (1) to the further mounting racks (25) coupled thereto.

5. Appliance system according to Claim 4, characterized in that the partitions (32, 46) are provided with fixed and/or controllable passage openings (51, 47, 48) for the cooling air.

6. Appliance system according to Claim 4 or 5, characterized in that baffles (53) are provided on the mounting racks for deflecting cooling air to the passage openings (51).

7. Appliance system according to one of Claims 4 to 6, characterized in that the pressure side of the cooling air blower (6) is connected to a first transfer channel (49) which is constructed on the outside, facing a mounting rack (25) to be coupled on, of the first mounting rack (1) and is outwardly open, and in that the mounting rack (25) to be coupled on has on the outside, facing the first mounting rack (1), at least one outwardly open second transfer channel (50) which at least partly overlaps the first transfer channel (49).

8. Appliance system according to one of Claims 1 to 7, characterized in that the mounting racks (1, 25) in each case have at least one wiring panel (4, 66) which is provided, on the one hand, with plug connectors (61) for plugging functional assemblies and, on the other hand, with connecting contacts (5) for connecting mounting racks (25, 1) coupled to functional assemblies.

9. Appliance system according to Claim 8, characterized in that the wiring panel (4) stands essentially perpendicular on the baseplate (8) and in that the connecting contacts (5) are arranged on the free upper edge, the plug connectors (61) on the side surface, facing the interior of the mounting rack, of the wiring panel (4).

10. Appliance system according to Claim 8 or 9, characterized in that the wiring panel (4) is arranged parallel to an outer edge of the baseplate (8) and offset inwardly with respect to said baseplate and forms the inner limit panel of a transfer channel (49).

11. Appliance system according to one of Claims 8 to 10, characterized in that the wiring panel (4), together with a partition (46) parallel thereto, forms an inner cooling air channel.

12. Appliance system according to one of Claims 1 to 11, characterized in that the partitions (30, 32; 56, 57) are provided with guide ribs (63, 65; 58) which serve as mounting rails for functional assemblies (64, 59, 60) and/or wiring panels (66).

13. Appliance system according to one of Claims 1 to 12, characterized in that at least part of the partitions (partition 31) is provided with bushing openings (85) for connecting cables.

14. Appliance system according to one of Claims 1 to 13, characterized in that cover hoods (14) are provided of a plan shape and size which in each case correspond to a mounting rack (1) as well as cover hoods (67; 81) which have a plan shape and size which in each case correspond to a plurality of mounting racks (1, 25; 76, 77, 78, 79) which are coupled together.

15. Appliance system according to Claim 14, characterized in that the cover hoods (14) are provided with openings (19) for feeding and openings for discharging cooling air.

16. Appliance system according to Claim 14 or 15, characterized in that the cover hoods (14) are provided with openings (21) for bushing electrical cables.

17. Appliance system according to one of Claims 14 to 16, characterized in that the side panels (73, 74, 75) of the cover hoods (72) are wholly or partly constructed as removable screens (74b, 75b) which close openings which allow access to the functional assemblies.

18. Appliance system according to one of Claims 1 to 17, characterized in that the mounting racks (25) have lateral push-in openings (86, 87) for pushing in functional assemblies (62, 64) essentially in the direction parallel to the baseplate (27).

19. Appliance system according to Claim 18, characterized in that the mounting racks (25) have at least two push-in openings whose push-in directions are angularly offset by 90° relative to one another.

## Revendications

1. Système d'appareils comportant un premier appareil électrique, auquel peut être accouplé mécaniquement et électriquement au moins un autre appareil électrique, et dans lequel les appareils possèdent chacun un porte-modules (1,25), agencé de manière à loger des modules fonctionnels et sur lesquelles sont disposés respectivement des dispositifs d'accouplement mécanique (23,24,33,34; 22,35) pour accoupler un porte-modules (1) à d'autres porte-modules (25), et dans lequel sont prévus des capots de recouvrement (14,67), qui sont adaptés à des ensembles déterminés de porte-modules accouplés entre eux et recouvrent ces derniers, caractérisé par le fait que les porte-modules (1,25) possèdent des parois de séparation (9,10,11,56,57; 28,29,30,31,32) qui sont perpendiculaires à une plaque de base (8;24), et que les dispositifs d'accouplement (23,24; 40;33,34,35) sont formés respectivement sur des parois de séparation (10,11; 31,32) de ces derniers, qui sont en aboutement lors de l'accouplement de deux porte-modules (1;25).

2. Système d'appareils suivant la revendication 1, caractérisé par le fait que les dispositifs d'accouplement comprennent des becs de verrouillage (33,34) disposés respectivement sur un porte-modules (25) et des ouvertures de logement (22,24) qui sont prévues dans un second porte-modules devant être accouplé à ce porte-modules (25), pour les becs de verrouillage (35).

3. Système d'appareils suivant la revendication 1 ou 2, caractérisé par le fait que les dispositifs d'accouplement comprennent des crochets élastiques d'encliquetage (35) formés respectivement sur un porte-modules (25), et des surfaces d'encliquetage (40) qui coopèrent avec les crochets d'encliquetage et sont formées sur un second porte-modules (1), qui doit être accouplé à ce porte-modules (25).

4. Système d'appareils suivant l'une des revendications 1 à 3, caractérisé par le fait que parmi plusieurs porte-modules (1;25) accouplés entre eux, au moins un premier porte-modules (1) est équipé d'un ventilateur (6) délivrant de l'air de refroidissement et que des canaux de transfert (49,50), qui sont reliés à des ouvertures de passage (51,47,48) traversant les parois de séparation (32,46) prévus pour le passage de l'air de refroidissement depuis sépale premier porte-modules (1) aux autres porte-modules (25) accouplés à ce porte-module.

5. Système d'appareils suivant la revendication 4, caractérisé par le fait que les parois de séparation (32,46) sont équipées d'ouvertures de passage fixes et/ou réglables (51,47,48) pour l'air de refroidissement.

6. Système d'appareils suivant la revendication 4 ou 5, caractérisé par le fait que des surfaces directrices (53) servant à dévier l'air de refroidissement en direction des ouvertures de passage (51) sont prévues sur les porte-modules.

7. Système d'appareils suivant l'une des revendications 4 à 6, caractérisé par le fait que le côté refoulement du ventilateur (6) délivrant l'air de refroidissement est relié à un premier canal de passage (49), qui est formé sur la paroi extérieure du premier porte-modules (1), tournée vers un porte-modules (25) devant être accouplé, et est ouvert en direction de l'extérieur, et que le porte-modules (25) devant être accouplé comporte, sur la face extérieure tournée vers le premier porte-modules (25), au moins un second canal de passage (50), qui est ouvert vers l'extérieur et est en recouvrement au moins partiel avec le premier canal de transfert (49).

8. Système d'appareils suivant l'une des revendications 1 à 7, caractérisé par le fait que les porte-modules (1,25) comportent chacun au moins une paroi de câblage (4,66), équipée, d'une part, de connecteurs (61) pour le raccordement de modules fonctionnels et, d'autre part, de contacts de raccordement (5) pour le raccordement de porte-modules (25,1) accouplés à des modules fonctionnels.

9. Système d'appareils suivant la revendication 8, caractérisé en ce que la paroi de câblage (4) est sensiblement perpendiculaire à la plaque de base (8) et que les contacts de raccordement (5) sont disposés sur le bord supérieur libre et que les connecteurs (61) sont disposés sur la surface latérale de la paroi de câblage (4), qui est tournée vers l'intérieur du porte-modules.

10. Système d'appareils suivant la revendication 8 ou 9, caractérisé par le fait que la paroi de câblage (4) est disposée parallèlement à un bord extérieur de la plaque de base (8) et en étant décalée vers l'intérieur par rapport à ce bord et forme la paroi limite intérieure d'un canal de transfert (49).

11. Système d'appareils suivant l'une des revendications 8 à 10, caractérisé par le fait que la paroi de câblage (4) forme, avec une paroi de séparation (46) parallèle à la précédente, un canal intérieur pour l'air de refroidissement.

12. Système d'appareils suivant l'une des revendications 1 à 11, caractérisé par le fait que les parois de séparation (30,32;56,57) comportent des nervures de guidage (63,65; 58), qui sont utilisées en tant que rails de montage pour des modules fonctionnels (64,59,60) et/ou des parois de câblage (66).

13. Système d'appareils suivant l'une des revendications 1 à 12, caractérisé par le fait qu'au moins une partie des parois de séparation (paroi de séparation 31) est pourvue d'ouvertures de traversée (85) pour des câbles de liaison.

14. Système d'appareils suivant l'une des revendications 1 à 13, caractérisé par le fait que des capots de recouvrement (14) possédant un contour de base en projection horizontale et une taille, qui correspondent respectivement à ceux d'un porte-modules (1), ainsi que des capots de recouvrement (67; 81) sont équipés respectivement de plusieurs porte-modules (1,25;76,77,78,79) accouplés entre eux et possédant un contour en projection horizontale et une taille correspondants.

15. Système d'appareils suivant la revendication 14, caractérisé par le fait que les capots de recouvrement (14) sont équipés d'ouvertures (19) pour l'amenée de l'air de refroidissement et des ouvertures pour l'évacuation de l'air de refroidissement.

16. Système d'appareils suivant la revendication 14 ou 15, caractérisé par le fait que les capots de recouvrement (14) sont pourvus d'ouvertures (21) pour le passage de câbles électriques.

17. Système d'appareils suivant l'une des revendications 14 à 16, caractérisé par le fait que les parois latérales (73,74,75) des capots de recouvrement (72) sont réalisées en totalité ou en partie sous la forme de diaphragmes amovibles (74b,75b), qui ferment des ouvertures permettant un accès aux modules fonctionnels.

18. Système d'appareils suivant l'une des revendications 1 à 17, caractérisé par le fait que les porte-modules (25) possèdent des ouvertures latérales d'insertion (86,87) pour l'insertion de groupes fonctionnels (62,64) essentiellement dans une direction parallèle à la plaque de base (27).

19. Système d'appareils suivant la revendication 18, caractérisé par le fait que les porte-modules (25) possèdent au moins deux ouvertures d'insertion, dont les directions d'insertion sont décalées angulairement de 90° l'une par rapport à l'autre.
